# EUROPEAN PATENT APPLICATION

(11) **EP 1 433 583 A1**
(43) Date of publication of application: **30.06.2004**
(21) Application number: 02800263.2
(22) Date of filing: 25.09.2002
(51) Int. Cl.: B29C 43/20, B29C 43/32

(54) **CUSHIONING MATERIAL FOR HOT PRESSING AND PROCESS FOR PRODUCING THE SAME**

(30) Priority: 28.09.2001 JP 2001299327
(71) Applicant: Yamauchi Corporation, Hirakata-shi, Osaka 573-1132 (JP)
(72) Inventor: YOSHIDA, Akira, c/o YAMAUCHI CORPORATION, Hirakata-shi, Osaka 573-1132 (JP)
(74) Representative: Hoffmann, Jörg Peter, Dr. Ing.
(86) International application number: PCT/JP2002/010022
(87) International publication number: WO 2003/028972

(57) **Abstract**

In order to prevent any surface swelling, resulting from bleeding of a low molecular weight compounding agent contained in rubber, a cushioning pad for hot pressing has a rubber sheet 1, and a surface layer material 2 made of a porous heat-resistant resin film laminated on at least one face of rubber sheet 1. The porous film has an average pore diameter of 10 µm or less and the porous film has gas permeability of 0.1 cm3/cm2·sec or more.

## Description

### Technical Field

This invention relates to a cushioning Pad for hot pressing, and a production method thereof. More specifically, this invention relates to a cushioning pad for hot pressing which is used when an object product is subjected to pressing or thermocompression bonding in the process of producing a precision instrument component having a lamination structure, such as a printed circuit board including a copper-clad laminate, a flexible printed circuit board, a build-up multilayer lamination board, an IC card, a liquid crystal display panel, or a ceramic lamination board.

### Background Art

In the production of a precision instrument component having a lamination structure, such as a printed circuit board, there is used a method of sandwiching an object 7 between hot plates 8 as shown in Fig. 7 and, then, applying a predetermined pressure and heat thereto in the process of pressing or thermocompression bonding. In order to obtain a molded product with high precision, it is necessary to make the heat and pressure applied to object 7 to be pressed uniform over the whole of the surface thereof in the hot pressing. For such a purpose, the hot pressing is performed in the state where a planar cushioning pad 9 is interposed between hot plates 8 and object 7 to be pressed.

As cushioning pad 9 for hot pressing, various kinds of materials are used, such as kraft paper, organic or inorganic fibers bonded with a binder, rubber, nonwoven fabric, and a laminate made of rubber and nonwoven fabric. Basically, the materials other than kraft paper are repeatedly used for a plurality of pressings. A cushioning pad having rubber elasticity in the surface thereof is superior in the effect of making heat and applied power uniform in the whole of the flat surface. Furthermore, even in the case where object 7 includes irregularities based on circuits or the like, the cushioning pad follows the irregularities of object 7 to make it possible to apply pressure to object 7. Therefore, this cushioning pad is particularly suitable for hot pressing of a precision instrument component required to give a high-precision component.

However, rubber has a bad releasing ability and further low molecular weight compounding agents contained in the rubber bleed out while the rubber is used under heat and pressurization. Therefore, in the case where a rubber having no releasing layer on the surface thereof is used, there arises a problem that the rubber adheres closely to an object to be pressed or contaminates the object to be pressed. Thus, it can be supposed that a releasing layer is formed on the surface of the rubber.

Japanese Patent No. 2649899 (Japanese Patent Laying-Open No. 8-90577) discloses a cushioning pad for hot press wherein anti-bleeding layer is formed on the surface of a rubber layer. It is recognized that as the anti-bleeding layer, preferred is a film-form material having both of gas non-permeability and releasing ability, more specifically a synthetic resin film, a metal foil or the like.

However, the cushioning pad disclosed in Japanese Patent No. 2649899 has the following problem since the gas non-permeable anti-bleeding layer is formed on the surface of the rubber layer. That is, at the stage of producing the cushioning pad for hot pressing or at the time of using the cushioning pad for hot pressing repeatedly, an excessive low molecular weight compounding agent contained in the rubber bleeds out, and this remains between the rubber layer and the anti-bleeding layer so that the surface of the cushioning pad is easily swelled. In the cushioning pad wherein such swellings are generated in the surface, the flatness thereof is bad and the effect of making heat and pressure uniform is damaged. Thus, the cushioning pad cannot be any longer used. While the cushioning pad for hot pressing is repeatedly used, the excessive low molecular weight compounding agent contained in the rubber bleeds as a bled material outwards from ends of the cushioning pad. Thus, a problem that the agent contaminates an object to be pressed is caused.

Thus, an object of this invention is to provide a cushioning pad for hot pressing which does not generate, in the surface thereof, any swelling based on a low molecular weight compounding agent contained in a rubber, which does not give any anxiety of contamination based on bleeding of the low molecular weight compounding agent contained in the rubber from ends of the cushioning pad, and which has rubber elasticity in the surface thereof and good releasing ability, and a production method thereof.

### Disclosure of the Invention

In order to solve the above-mentioned problems, a cushioning pad for hot pressing according to this invention includes: a rubber sheet; and a surface layer material made of a porous heat-resistant resin film laminated on at least one surface of this rubber sheet.

According to the above-mentioned structure, the surface layer material is made of the porous film; therefore, at the stage of producing the cushioning pad for hot pressing, an excessive low molecular weight compounding agent contained in the rubber can be volatilized outwards through the porous film. Accordingly, both at the stage of producing the cushioning pad and at the time of using the cushioning pad, swelling in the surface, based on bleeding of the low molecular weight compounding agent contained in the rubber, is not generated. Since the excessive low molecular weight compounding agent contained in the rubber is volatilized outwards through the porous film at the stage of producing the cushioning pad for hot pressing, the anxiety is also removed that the low molecular weight compounding agent contained in the rubber bleeds out from ends of the cushioning pad at the time of using the cushioning pad so as to contaminate an object to be pressed. Furthermore, the rubber elasticity of the cushioning pad is not disturbed since the surface layer material is in the form of a film. Moreover, the releasing ability of the cushioning pad surface is also good since the surface layer material is made of the heat-resistant resin.

In order to volatilize effectively the excessive low molecular weight compounding agent contained in the rubber outwards through the porous film, the porous film preferably has a gas permeability of 0.1 cm3/cm2·sec or more. In order to prevent the low molecular weight compounding agent from bleeding out excessively, the porous film preferably has an average pore diameter of 10 µm or less. Furthermore, in order to keep good rubber elasticity in the surface of the cushioning pad, the porous film preferably has a thickness of 100 µm or less.

The heat-resistant resin, which constitutes the surface layer material, is preferably a fluoro plastic. The rubber is preferably a fluoro rubber.

In a preferred example, the cushioning pad has, on both surfaces thereof, a surface layer material made of a porous heat-resistant resin film.

In an example, the other face of the rubber sheet is provided with a layer of woven fabric, nonwoven fabric, paper, a film, a foil, a sheet or a plate. In another example, the cushioning pad has an upper rubber sheet and a lower rubber sheet, which are laminated to sandwich an intermediate layer, and the surface layer materials are laminated on the surfaces of the upper rubber sheet and the lower rubber sheet.

A production method of a cushioning pad for hot pressing according to this invention includes the steps of: laminating a surface layer material made of a porous film on at least one face of an unvulcanized rubber sheet; primarily vulcanizing the unvulcanized rubber sheet while heat and pressure are applied thereto, thereby bonding and integrating this primarily vulcanized rubber sheet and the porous film with each other; and secondarily vulcanizing the primarily vulcanized rubber sheet, thereby volatilizing an excessive low molecular weight compounding agent contained in the primarily vulcanized rubber sheet outwards through the porous film.

According to such a production method, the surface layer material is made to a porous film, and in the secondary vulcanization an excessive low molecular weight compounding agent contained in the rubber is volatilized outwards through the porous film. Accordingly, both at the stage of producing the cushioning pad and at the time of using the cushioning pad, swellings, based on bleeding of the low molecular weight compounding agent contained in the rubber, are not generated. Since the excessive low molecular weight compounding agent contained in the rubber is volatilized outwards through the porous film at the stage of producing the cushioning pad for hot pressing, the anxiety that the low molecular weight compounding agent contained in the rubber bleeds out from ends of the cushioning pad at the time of using the cushioning pad so as to contaminate an object to be pressed is also removed. Furthermore, the rubber elasticity of the cushioning pad is not disturbed since the surface layer material is a film. Moreover, the releasing ability of the cushioning pad surface is also good since the surface layer material is made of the heat-resistant resin.

In another aspect, the production method of a cushioning pad for hot pressing according to this invention includes the steps of: laminating a surface layer material made of a porous film on one face of an unvulcanized rubber sheet; laminating a layer of woven fabric, nonwoven fabric, a film, a foil, a sheet or a plate on the other face of the unvulcanized rubber sheet; primarily vulcanizing the unvulcanized rubber sheet while heat and pressure are applied thereto, thereby bonding and integrating the layers laminated on both the faces of this primarily vulcanized rubber sheet with each other; and secondarily vulcanizing the primarily vulcanized rubber sheet, thereby volatilizing an excessive low molecular weight compounding agent contained in the primarily vulcanized rubber sheet outwards through the porous film.

### Brief Description of the Drawings

Fig. 1 is a sectional view showing an example of a cushioning pad for hot pressing according to the present invention.
Fig. 2 is a sectional view showing another example of the cushioning pad for hot pressing according to the present invention.
Fig. 3 is a sectional view showing still another example of the cushioning pad for hot pressing according to the present invention.
Fig. 4 is a sectional view showing yet another example of the cushioning pad for hot pressing according to the present invention.
Fig. 5 is a sectional view showing yet another example of the cushioning pad for hot pressing according to the present invention.
Fig. 6 is a sectional view showing yet another example of the cushioning pad for hot pressing according to the present invention.
Fig. 7 is a conceptual view for describing hot pressing using a cushioning pad.

### Best Modes for Carrying Out the Invention

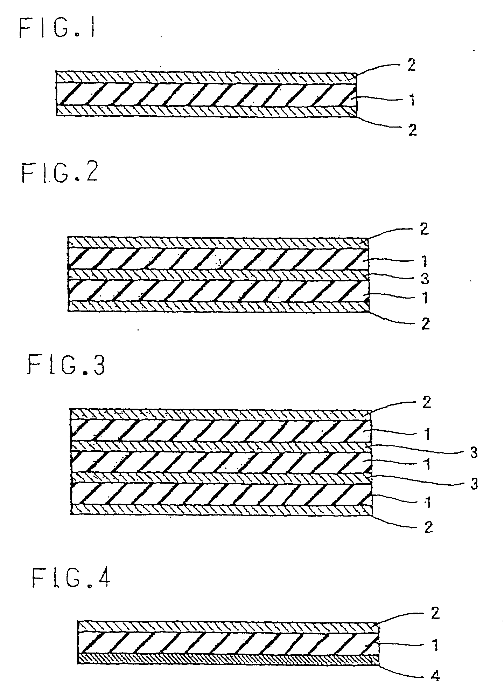

Hereinafter, examples of the present invention will be described with reference to the drawings. Figs. 1 to 6 show typical examples of a cushioning pad for hot pressing according to the present invention.

The cushioning pad for hot pressing according to this invention has a structure wherein a surface layer material 2 made of a porous heat-resistant resin film is laminated on and integrated with at least one face of a rubber sheet 1.

As the material of rubber sheet 1, a rubber having heat resistance can be used. Specifically, preferred are fluoro rubber, EPM, EPDM, hydrogenated nitrile rubber, silicone rubber, acrylic rubber, butyl rubber and the like. These rubber materials can be used alone, in the form of a blend thereof, or in the form of a blend thereof with an organic or inorganic material other than the above. Among these, fluoro rubber is preferably used from the standpoint of superior heat resistance. In particular, a polyol vulcanized vinylidene fluoride copolymer is optimal since it is superior in compression set property. As the polyol vulcanized vinylidene fluoride copolymer, "DAI-EL" G-700 series (manufactured by Daikin Industries, Ltd.), which is commercially available, can be preferably used.

The porous heat-resistant resin film used as surface layer material 2 is preferably made to have an average pore diameter of 10 µm or less. The porous film is preferably made to have a gas permeability of 0.1 cm3/cm2·sec or more. The gas permeability is a gas permeability according to the A method defined in JIS L1096. More preferably, the average pore diameter is set to 10 µm or less, and the gas permeability is set to 0.1 cm3/cm2·sec or more. In this way, any excessive low molecular weight compounding agent contained in the rubber can be volatilized outwards through the porous film at the stage of producing the cushioning pad for hot pressing. Examples of the excessive low molecular weight compounding agent contained in the rubber include a vulcanizing agent and a plasticizer. If the average pore diameter of the porous film exceeds 10 µm and too large, rubber 1 protrude from pores in porous film 2 to the surface at the stage of producing the cushioning pad for hot pressing. Thus, there is a possibility that the smoothness and the releasing ability of the surface of the cushioning pad are disturbed. Thus, this case is not preferred. If the gas permeability of the porous film is less than 0.1 cm3/cm2·sec, it is difficult to remove sufficiently the excessive low molecular weight compounding agent contained in the rubber. Thus, this case is not preferred.

Furthermore, the porous film is preferably made to have a thickness of 100 µm or less. In this way, the surface of the cushioning pad for hot pressing can exert rubber elasticity. If the thickness of the porous film is larger than 100 µm, the rubber elasticity of the surface of the cushioning pad for hot pressing is disturbed. Thus, this case is not preferred.

Furthermore, the porous film is made of a heat-resistant resin having a melting point of 210°C or more. More specifically, the film is preferably made of a polyimide resin or a fluoro plastic. Particularly preferably, the film is made of polytetrafluoroethylene (PTFE). The use of such a material causes the surface of the cushioning pad for hot pressing to have good releasing ability from an object to be hot-pressed.

As a porous film having these properties, for example, "MICRO-TEX NTF" manufactured by Nitto Denko Corp. is commercially available.

In the cushioning pad for hot pressing according to this invention, surface layers 2 made of the porous film may be laminated on and integrated with both faces of rubber sheet 1, as shown in Fig. 1. The cushioning pad may have a structure wherein surface layer material 2 is laminated on and integrated with one face of rubber sheet 1 and one or more layers made of one or more selected from woven fabric, nonwoven fabric, paper, a film, a foil, a sheet and a plate are laminated on and integrated with the other face. The material which is laminated on the other face of the rubber sheet may be appropriately selected dependently on the object to be hot-pressed, pressing conditions, and the like.

A cushioning pad for hot pressing shown in Fig. 2 has, in each of the upper and lower portions, a structure wherein a surface layer material 2 made of a porous film is laminated on one face of a rubber sheet 1 and has a structure wherein the faces of upper and lower rubber sheets 1 on which surface layer materials 2 are not laminated are opposed to each other and the middle between them is reinforced with a cloth 3. As cloth 3, a heat-resistant cloth, such as glass cloth or aromatic polyamide cloth, is preferably used.

A cushioning pad for hot pressing shown in Fig. 3 has, in each of the upper and lower portions, a structure wherein surface layer material 2 made of a porous film is laminated on one face of rubber sheet 1 and has a structure wherein the faces of upper and lower rubber sheets 1 on which surface layer materials 2 are not laminated are opposed to each other and a laminate of a cloth 3, another rubber sheet 1 and another cloth 3 are sandwiched therebetween.

A cushioning pad for hot pressing shown in Fig. 4 has a structure wherein a surface layer material 2 made of a porous film is laminated on one face of a rubber sheet 1 and a reinforcing plate 4 is laminated on the other face. As reinforcing plate 4, a metal plate made of aluminum, stainless steel or the like, a plate made of fiber-reinforced resin, or some other plate can be used.

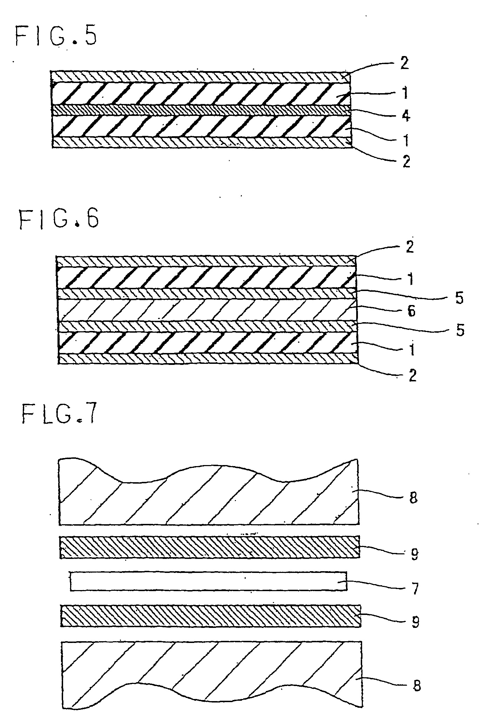

A cushioning pad for hot pressing shown in Fig. 5 has, in each of the upper and lower portions, a structure wherein a surface layer material 2 made of a porous film is laminated on one face of a rubber sheet 1 and has a structure wherein the faces of upper and lower rubber sheets 1 on which surface layer materials 2 are not laminated are opposed to each other and the middle between them is reinforced with reinforcing plate 4.

A cushioning pad for hot pressing shown in Fig. 6 has, in each of the upper and lower portions, a structure wherein surface layer material 2 made of a porous film is laminated on one face of rubber sheet 1 and has a structure wherein the faces of upper and lower rubber sheets 1 on which surface layer materials 2 are not laminated are opposed to each other and a laminate of an adhesive material 5, a nonwoven fabric 6 and another adhesive material 5 are sandwiched therebetween. As adhesive material 5, preferably used is an adhesive material wherein a woven fabric such as glass cloth is coated or impregnated with a heat-resistant rubber such as fluoro rubber. As nonwoven fabric 6, a nonwoven fabric made of a single or a mixture of polyamide fiber, aromatic polyamide fiber, polybenzoxazole (PBO), and the like can be used.

Figs. 1 to 6 merely show typical examples of the present invention. The cushioning pad of the present invention can be naturally modified into embodiments other than these within the scope which satisfies the requirements of the present invention.

Next, description will be given of a production method of a cushioning pad for hot pressing according to the present invention.

First, respective constituent materials of the cushioning pad for hot pressing are laminated. At this time, at least one surface thereof is made into a structure wherein surface layer material 2 made of a porous film is laminated on a surface of rubber sheet 1 in an unvulcanized state. For example, in the case where the cushioning pad for hot pressing shown in Fig. 1 is produced, surface layer material 2 made of a porous film is laminated on both faces of unvulcanized state rubber sheet 1.

Next, unvulcanized state rubber sheet 1 is primarily vulcanized while heat and pressure are applied thereto, thereby rubber sheet 1 and porous film 2 are bonded and integrated with each other. The primary vulcanization can be performed by press vulcanization, for example, under conditions of 160°C to 200°C and 0.098 MPa to 3.92 MPa (1 kgf/cm2 to 40 kgf/cm2) for 5 minutes to 120 minutes.

Thereafter, rubber sheet 1 integrated with surface layer material 2 made of the porous film is secondarily vulcanized, thereby volatilized an excessive low molecular weight compounding agent contained in rubber sheet 1 after the primary vulcanization outwards through porous film 2. Thus, a cushioning pad for hot pressing can be obtained. The secondary vulcanization is preferably performed at a temperature not less than the boiling point of a plasticizer contained in rubber sheet 1 and a temperature not less than the use temperature of the press. If the temperature of the secondary vulcanization is too low, the low molecular weight compounding agent cannot be sufficiently volatilized outwards. If the temperature is too high, the rubber deteriorates. Thus, the secondary vulcanizing temperature is preferably from about 200°C to 260°C. The secondary vulcanization is preferably performed for one or more hours (more preferably from 4 to 48 hours). The secondary vulcanization is performed without application of additional pressure in the state where the surface of porous film 2 is opened. In this way, the low molecular weight compounding agent contained in rubber sheet 1 can be effectively volatilized.

In the examples shown in Figs. 2 to 6, at least one surface of the lamination structure is caused to have a structure wherein surface layer material 2 made of the porous film is laminated on one face of unvulcanized state rubber sheet 1. In the case where surface layer material 2 made of the porous film is laminated on one face of non-vulcanized state rubber sheet 1, one or more layers made of one or more selected from woven fabric, nonwoven fabric, paper, a film, a foil, a sheet or a plate can be laminated on the other face. Next, heat and pressure are applied to the whole of the lamination structure, thereby primarily vulcanizing unvulcanized state rubber sheet 1, and further all the elements are bonded and integrated. Conditions for the primary vulcanization are similar to the case of Fig. 1. Thereafter, in the way similar to the case of Fig. 1, rubber sheet 1 is secondarily vulcanized, thereby volatilizing any excessive low molecular weight compounding agent contained in rubber sheet 1 after the primary vulcanization outwards through porous film 2. Thus, a cushioning pad for hot pressing can be obtained.

### Industrially Applicability

This invention can be suitably applied to a cushioning pad for hot pressing which is used to press or thermocompress an object product such as a copper-clad laminate, a printed circuit board, an IC card, a liquid crystal display panel, a ceramic lamination board or the like.

## Claims

1. A cushioning pad for hot pressing, comprising:
a rubber sheet (1); and
a surface layer material (2) made of a porous heat-resistant resin film laminated on at least one face of said rubber sheet (1).

2. The cushioning pad for hot pressing according to claim 1, wherein
the average pore diameter of said porous film is 10 µm or less.

3. The cushioning pad for hot pressing according to claim 1, wherein
said porous film has gas permeability of 0.1 cm3/cm2·sec or more.

4. The cushioning pad for hot pressing according to claim 1, wherein
the thickness of said porous film is 100 µm or less.

5. The cushioning pad for hot pressing according to claim 1, wherein
said heat-resistant resin is a fluoro plastic.

6. The cushioning pad for hot pressing according to claim 1, wherein
said rubber is a fluoro rubber.

7. The cushioning pad for hot pressing according to claim 1, wherein
the other face of said rubber sheet is provided with a layer of woven fabric, nonwoven fabric, paper, a film, a foil, a sheet or a plate.

8. The cushioning pad for hot pressing according to claim 1, comprising said surface layer materials (2) on both the surfaces.

9. The cushioning pad for hot pressing according to claim 8, comprising an upper rubber sheet and a lower rubber sheet, which are laminated to sandwich an intermediate layer, and
said surface layer materials are laminated on the surfaces of said upper rubber sheet and said lower rubber sheet.

10. A production method of a cushioning pad for hot pressing, comprising the steps of:
laminating a surface layer material made of a porous film on at least one face of an unvulcanized rubber sheet;
primarily vulcanizing said unvulcanized rubber sheet while heat and pressure are applied thereto, thereby bonding and integrating this primarily vulcanized rubber sheet and said porous film with each other; and
secondarily vulcanizing said primarily vulcanized rubber sheet, thereby volatilizing an excessive low molecular weight compounding agent contained in said primarily vulcanized rubber sheet outwards through said porous film.

11. A production method of a cushioning pad for hot pressing, comprising the steps of:
laminating a surface layer material made of a porous film on one face of an unvulcanized rubber sheet;
laminating a layer of woven fabric, nonwoven fabric, a film, a foil, a sheet or a plate on the other face of said unvulcanized rubber sheet;
primarily vulcanizing said unvulcanized rubber sheet while heat and pressure are applied thereto, thereby bonding and integrating the layers laminated on both the faces of this primarily vulcanized rubber sheet with each other; and
secondarily vulcanizing said primarily vulcanized rubber sheet, thereby volatilizing an excessive low molecular weight compounding agent contained in said primarily vulcanized rubber sheet outwards through said porous film.
